(19) Europäisches Patentamt
European Patent Office
Office européen des brevets

(11) Publication number: **0 218 228 B1**

(12) **EUROPEAN PATENT SPECIFICATION**

(45) Date of publication of patent specification: **15.09.93**

(51) Int. Cl.$^5$: **C08L 63/00**

(21) Application number: **86113812.1**

(22) Date of filing: **06.10.86**

(54) **Epoxy resin composition.**

(30) Priority: **07.10.85 JP 224210/85**
**07.10.85 JP 224211/85**

(43) Date of publication of application:
**15.04.87 Bulletin 87/16**

(45) Publication of the grant of the patent:
**15.09.93 Bulletin 93/37**

(84) Designated Contracting States:
**DE FR GB IT NL**

(56) References cited:
**GB-A- 906 544**
**JP-A- 5 821 417**
**JP-A-59 129 252**
**US-A- 4 376 174**

(73) Proprietor: **Shin-Etsu Chemical Co., Ltd.**
**6-1, Otemachi 2-chome**
**Chiyoda-ku Tokyo 100(JP)**

(72) Inventor: **Itoh, Kunio Shin-Etsu Chemical Co. Ltd.**
**Silicone Electr. Materials Research Center**
**13-1**
**Isobe 2-chome Annaka-shi Gunmaken(JP)**
Inventor: **Shiobara, Toshio Shin-Etsu Chemical Co. Ltd.**
**Silicone Electr. Materials Research Center**
**13-1**
**Isobe 2-chome Annaka-shi Gunmaken(JP)**
Inventor: **Futatsumori, Koji Shin-Etsu Chemical Co. Ltd.**
**Silicone Electr. Materials Research Center**
**13-1**
**Isobe 2-chome Annaka-shi Gunmaken(JP)**
Inventor: **Tomiyoshi, Kazutoshi Shin-Etsu Chemical Co. Ltd.**
**Silicone Electr. Materials Research Center**
**13-1**
**Isobe 2-chome Annaka-shi Gunmaken(JP)**
Inventor: **Shimizu, Hisashi Shin-Etsu Chemical Co. Ltd.**
**Silicone Electr. Materials Research Center**
**13-1**
**Isobe 2-chome Annaka-shi Gunmaken(JP)**

(74) Representative: **TER MEER - MÜLLER - STEINMEISTER & PARTNER**
**Mauerkircherstrasse 45**
**D-81679 München (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).



Rank Xerox (UK) Business Services
(3.10/3.6/3.3.1)

## Description

### BACKGROUND OF THE INVENTION

#### Filed of the Invention

This invention relates to epoxy resin compositions which are suitable for use as molding materials, powder coating materials, encapsulators for semiconductors and the like.

#### Description of the Prior Art

Epoxy resin compositions comprising epoxy resins and inorganic fillers have better characteristics, e.g. moldability, adhesiveness, electric characteristics, mechanical characteristics, moisture proofness and the like, than other thermosetting resins. Accordingly, epoxy resin compositions have wide utility as various molding materials, powder coating materials and electric insulative materials, particularly as encapsulators for semiconductors.

However, most known epoxy resin compositions tend to crack upon curing, so that the appearance of the moldings and coatings is impeded and semiconductor elements or devices become defective.

In order to solve the above problems, the present inventors proposed epoxy resin compositions having a high resistance to cracking in which block copolymers of aromatic polymers and organopolysiloxanes are added to curable epoxy resins (Japanese Patent Application Laid-Open No. 58-21417). JP-A-59-129 252 discloses epoxy resin compositions comprising an epoxy resin, such as a novolak type or a bisphenol type epoxy resin, if necessary a curing agent and a filler, as well as an amino modified silicone resin. GB-A-906 544 relates to resinous reaction products of organofunctional-silicone compounds and epoxy compounds and to processes for forming such resinous reaction products. However, there is a high demand for epoxy resin compositions which have a high resistance to cracking, a high glass transition point and a low coefficient of expansion, so that the degree of deformation upon molding is small with good moldability without a sacrifice of mechanical characteristics such as the bending strength, the modulus of elasticity in flexure and the like mechanical strength.

### SUMMARY OF THE INVENTION

It is, accordingly, an object of the present invention to provide an epoxy resin composition which has without a sacrifice of mechanical strength such as the bending strength and the modulus of elasticity in flexure, a low coefficient of expansion, a high glass transition point and a high resistance to cracking with a reduced degree of deformation at the time of molding.

In order to achieve the above object, the present inventors made intensive studies on copolymer components which can bring about a good effect on the cracking resistance by incorporation into epoxy resin compositions comprising curable epoxy resins and curing agents as prominent components. As a result, it was found that copolymers obtained by addition of organopolysiloxanes containing $\geqslant$SiH groups to alkenyl group-containing epoxy resins and copolymers obtained by addition of organopolysiloxans having amino groups to epoxy resins exhibit good characteristics as formulation agents for expoxy resin compositions. These copolymers contain little or no free organopolysiloxanes which are not bonded to epoxy resins. In addition, the copolymers have a varying solubility parameter after formation by the reaction depending on the type of epoxy resin. In case where organopolysiloxanes having a relatively low molecular weight of from 1500 to 5000 are used, the solubility parameter is appoximately in the range of from 7.3 to 8.5. Accordingly, the solubility in curable epoxy resins can be prevented by the use of such a copolymer. When the copolymers are formulated in epoxy resin compositions, the resultant composition has not only a glass transition point which does not lower but increases approximately by 10 °C, but also a low coefficient of expansion. In addition, the copolymers contain the same or similar epoxy resin segments as the curable epoxy resins and have thus high affinity for the curable epoxy resin. This permits microscopic dispersion with a drastically improved resistance to cracking. Such a composition ensures a small degree of deformation of aluminium electrodes in case that the composition is used as an encapsulator for a semiconductor. The present invention is accomplished based on the above findings.

According to the present invention, there is provided an epoxy resin composition which comprises (I) a curable epoxy resin having at least two epoxy groups and which is not modified with silicones, (II) a curing agent selected from the group consisting of diaminodiphenylmethane, diaminodiphenylsulfone, metaphenylenediamine, acid anhydride curing agents and phenol novolac curing agents having two or more

hydroxyl groups in the molecule, (III) an inorganic filler in an amount of 100 to 1000 parts by weight per 100 parts by weight of the total of the epoxy resin and the curing agent, (IV) at least one copolymer selected from the following copolymers [A] and [B] in an amount of 1 to 100 parts by weight per 100 parts by weight of the total of the epoxy resin and the curing agent, [A] copolymers obtained by addition reaction between alkenyl group-containing epoxy resins and hydrogen-terminated (2-trimethoxysilylethyl)-polysiloxanes of the following formula (1)

$$H_aR_bSiO_{\frac{4-(a+b)}{2}} \qquad (1)$$

in which each R represents a substituted or unsubstituted monovalent hydrocarbon group, "a" is a value of from 0.01 to 0.1, "b" is a value of 1.8 to 2.2 and $1.81 < a + b < 2.3$, and the number of silicon atoms in a molecule is an integer of from 20 to 400 and the number of hydrogen atoms directly connected to silicon atom is an integer of from 1 to 5;
[B] a copolymer obtained by an addition reaction between novolak epoxy resins and amino group-containing organopolysiloxanes of the following formula (2)

$$(H_2N\text{-}R^1)_aR^2_bSiO_{\frac{4-(a+b)}{2}} \qquad (2)$$

in which $R^1$ represents a divalent organic group, $R^2$ is independently selected from methyl group, phenyl group,
$-CH_2CH_2Si(OCH_3)_3$ and

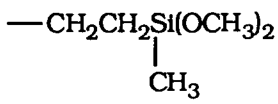

wherein part of said $R^2$'s is
$-CH_2CH_2Si(OCH_3)_3$ or

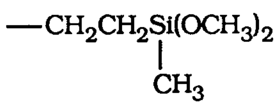

"a" is a value of from 0.01 to 0.1, "b" is a value of from 1.8 to 2.2 and $1.81 < a + b < 2.3$, and the number of silicon atoms in one molecule is an integer of from 20 to 400.

The epoxy resin composition of the invention comprises, aside from a curable epoxy resin, a curing agent and an inorganic filler, the copolymer [A] obtained by addition reaction between an alkenyl group-containing epoxy resin and an organopolysiloxane with a $\geqslant$SiH structure having a specific degree of polymerization and/or the copolymer [B] obtained by addition reaction between novolak epoxy resins and an amino group-containing organopolysiloxane having a specific degree of polymerization. By the incorporation of these copolymers, the epoxy resin composition has a low coefficient of expansion, a high glass transition point, a high resistance to cracking and a very small degree of deformation of aluminium electrodes without reduction of mechanical strengths such as the bending strength and the modulus of elasticity in flexure. Such a composition is particularly suitable for use as molding materials, powder coating materials and encapsulations for semiconductors.

DETAILED DESCRIPTION OF THE INVENTION

The curable epoxy resins useful in the present invention are those epoxy resins which have two or more epoxy groups in one molecule thereof. The epoxy resins are not critical with respect to the molecular structure, molecular weight and the like so far as they are cured by means of a variety of curing agents described hereinafter. In this sense, a number of currently known epoxy resins may be used for the purpose of the invention. Examples of the epoxy resins include epoxy resins prepared from various types of novolac resins including epichlorohydrin, bisphenol and the like, alicyclic epoxy resins, epoxy resins having halogen atoms such as chlorine, bromine or the like introduced thereinto, and the like. The epoxy resins are not limited to the single use, but may be used in combination.

These epoxy resins may be used in combination with monoepoxy resins. Examples of the monoepoxy resins include resins based on styrene oxide, cyclohexene oxide, propylene oxide, methyl glycidyl ether, ethyl glycidyl ether, phenyl glycidyl ether, allyl glycidyl ether, octylene oxide, dodecene oxide and the like.

The curing agents may be amine curing agents, mainely diaminodiphenylmethane, diaminodiphenylsulfone and metaphenylenediamine, acid anhydride curing agents such as, for example, phthalic anhydride, pyromellitic anhydride, and benzophenonetetracarboxylic anhydride, and phenol novolac curing agents having two or more hydroxyl groups in the molecule thereof such as, for example, phenol novolac and cresol novolac.

In the practice of the invention, a variety of curing promotors may be used in order to promote the reaction between the curing agent and the epoxy resin. Examples of the promotors include imidazoles or their derivatives, tertiary amine derivatives, phosphine derivatives, cycloamidine derivatives and the like.

The curing agent is used in amounts ordinarily used for these purposes although the amount of the curing agent may preferably be 20 to 100 % based on the equivalent of the epoxy group of the epoxy resin and the amount of a curing promotor may be within a range ordinarily used.

When the amount of the inorganic fillers used in the present invention is less than 100 parts by weight per 100 parts by weight of the total of the epoxy resin and curing agent, the resulting epoxy resin composition may, in some cases, have a low stress and may not show satisfactory results with respect to physical characteristics such as a cracking resistance. On the other hand, when the amount exceeds 1000 parts by weight, the fluidity becomes poor, so that the dispersion of inorganic filler may become difficult. Accordingly, the amount is in the range of from 100 to 1000 parts by weight, preferably from 250 to 750 parts by weight. The inorganic fillers are not critical with respect to the kind and may be used singly or in combination. The fillers should be properly selected depending on the purpose of the epoxy resin composition. For instance, natural silica such as crystalline silica or non-crystalline silica, synthetic highly pure silica, synthetic spherical silica, talc, mica, silicon nitride, boron nitride, alumina and the like are used singly or in combination.

The copolymer formulated in the epoxy resin composition of the invention is one or more copolymers selected from [A] reaction products obtained by addition reaction between alkenyl group-containing epoxy resins and hydrogen-terminated (2-trimethoxysilylethyl)-polysiloxanes of the following formula (1)

$$H_aR_bSiO_{\frac{4-(a+b)}{2}} \qquad (1)$$

in which each R repesents a substituted or unsubstituted monovalent hydrocarbon group, "a" is a value of from 0.01 to 0.1, "b" is a value of from 1.8 to 2.2 and 1.81 < a + b < 2.3, and the number of silicon atoms in a molecule is an integer of rom 20 to 400 and the number of hydrogen atoms directly connected to silicon atom is an interger of from 1 to 5, and [B] reaction products obtained by an addition reaction between novolak epoxy resins and amino group-containing organopolysiloxanes of the following formula (2)

$$(H_2N\text{-}R^1)_aR^2_bSiO_{\frac{4-(a+b)}{2}} \qquad (2)$$

in which $R^1$ represents a divalent organic group, $R^2$ is independently selected from methyl group, phenyl group,

$-CH_2CH_2Si(OCH_3)_3$ and

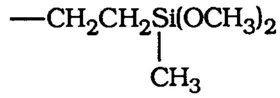

wherein part of said $R^2$'s is
$-CH_2CH_2Si(OCH_3)_3$ or

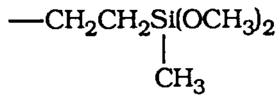

"a" is a value of from 0.01 to 0.1, "b" is a value of from 1.8 to 2.2 and $1.81 < a + b < 2.3$, and the number of silicon atoms in one molecule is an interger of rom 20 to 400.

The alkenyl group-containing epoxy resins used to prepare the copolymers [A] include those resins which are obtained by epoxidizing alkenyl group-containing phenolic resins with epichlorohydrin or by partial reaction of 2-allylphenol with known epoxy resins. Specific examples of these reins are compounds of the following formulae (3) to (5)

Formula (3):

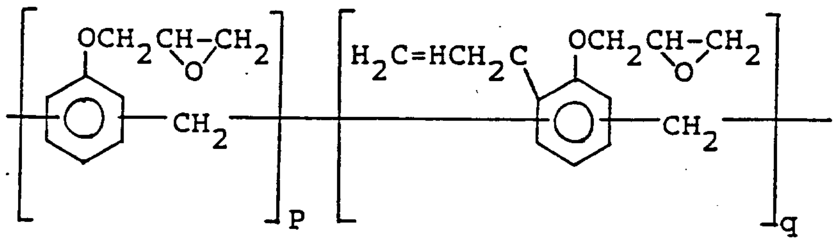

Formula (4) :

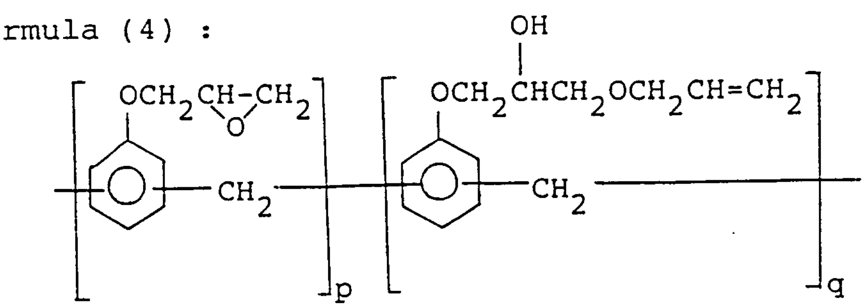

Formula (5) :

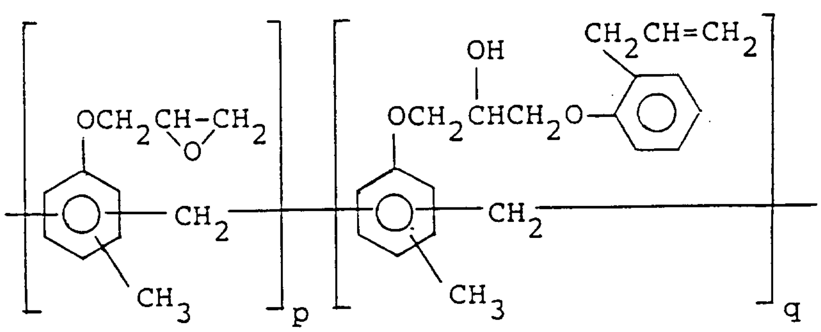

in which p and q are, respectively, a positive value determined such that $1 < p < 10$ and $1 < q < 3$.

The organopolysiloxanes represented by the formula (1) may be any hydrogen-terminated-(2-trimethoxysilylethyl)-polysiloxanes Specific examples include those compounds of the following formula (10)

Formula (10) :

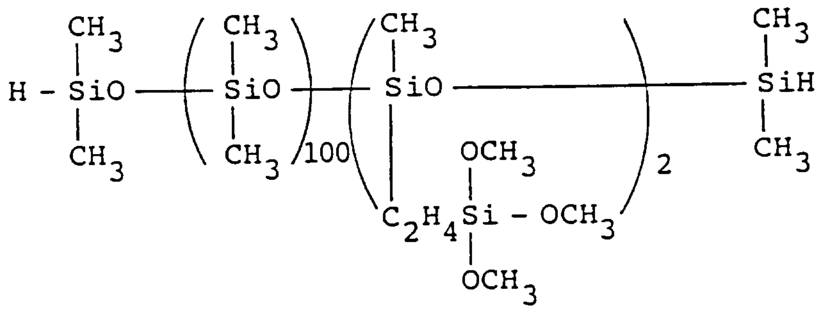

The organopolysiloxanes of the formula (1) has generally a degree of polymerization "N" of from 20 to 400, preferably from 30 to 200. In the case where "N" is less than 20, it is difficult to impart adequate flexibility and a high glass transition point (Tg), whereas when "N" is over 400, preparation of the copolymers is technically very difficult. In the event that copolymers are obtained, they cannot be readily dispersed, making it difficult to attain the purposes of the invention.

In general,as "N" increases, organopolysiloxanes show better results with respect to the cracking resistance and Tg for the same silicon content, but tend to lower in dispersability and adhesiveness to elements. In order to improve the dispersability and the adhesiveness to elements, it is effective and, in fact, preferable to introduce into side chains as shown in the formula (10) the following groups, e.g.

$-C_2H_4Si(OCH_3)_3$,

$-CH_2-CH_2COOCH_3Si(OCH_3)_3$ ,

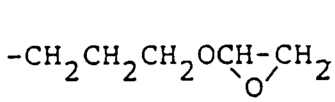 and 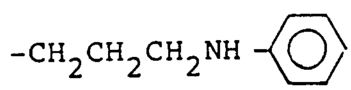.

The copolymers [A] can be obtained by thermal reaction between an alkenyl group-containing epoxy resin and an organopolysiloxane of the formula (1) having an $\geqslant$SiH group in the presence of a known addition catalyst, e.g. a platinum catalyst such as chloroplatinic acid. Preferably, the copolymer [A] should not be miscible with an epoxy resin in the epoxy resin composition and take a fine island structure in order that the resultant epoxy resin composition has a high glass transition point, a low coefficient of expansion and a high cracking resistance. In this sense, the copolymer [A] is preferred to have a solubility parameter of from 7.3 to 8.5, more preferably from 7.6 to 8.2. In order to obtain a copolymer whose solubility parameter is within the above range, when the equivalence of $\geqslant$SiH in the organopolysiloxane is taken as X and the molecular weight of the alkenyl group-containing epoxy resin is taken as Y, the reaction is preferably carried out in the range of $0.7 < X/Y < 7.0$.

The epoxy resins used to obtain the copolymer [B] may favorably be various epoxy resins which have two or more epoxy groups in one molecule and which are obtained from various novolac resins including epichlorohydrin and bisphenol. In addition, the curable epoxy resins indicated before may be also used for this purpose.

The amino group-containing organopolysiloxanes represented by the formula (2) may be organopolysiloxanes having at least one amino group in the molecule thereof. It is preferred that in the formula (2), $R^2$s are a methyl group and $-CH_2CH_2Si(OCH_3)_3$ in combination. Specific examples include those compounds of the following formula (14)

Formula (14) :

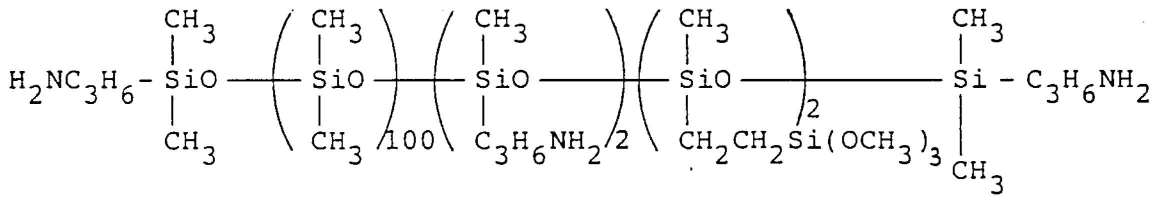

The amino group-containing organopolysiloxanes of the formula (2) have generally a degree of polymerization "N" of from 20 to 400, preferably from 30 to 2OO. If "N" is less than 20, the resultant polysiloxane is not imparted with satisfactory flexibility and a high glass tansition point (Tg). On the contrary, when "N" exceeds 400, it is technically very difficult to obtain copolymers. Even if copolymers are obtained, they cannot readily be dispersed thus making it impossible to attain the purposes of the invention.

In general, organopolysiloxanes can give better results with respect to the cracking resistance and the tendency toward a high glass transition point as "N" increases for the same silicon level. However, the dispersability and the adhesiveness to elements tend to lower. In order to improve the dispersability and the adhesiveness to elements, part of $R^2$ is a group

$-CH_2CH_2Si(OCH_3)_3$,

or

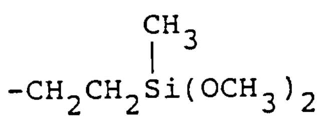

These amino group-containing organopolysiloxanes can be obtained by subjecting a starting material such as, for example,

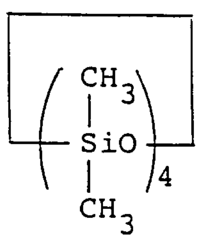

,

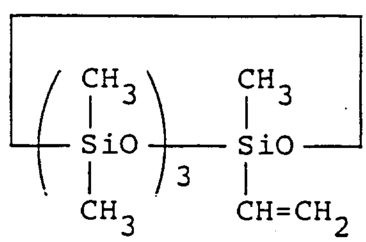

and

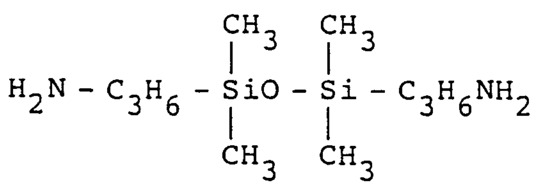

to a known equilibration reaction to give a polymer and further subjecting $HSi(OCH_3)_3$ to addition reaction with the polymer.

The copolymer [B] is obtained by mixing a novolak epoxy resin as indicated before and said amino group-containing organopolysiloxane at normal temperatures or high temperature and subjecting the mixture to addition reaction. In order to mix both starting materials uniformly or substantially uniformly for the reaction, it is preferred to use a solvent such as methyl isobutyl ketone, toluene, dioxane, methyl cellosolve ® or the like. Preferably, the reaction should be accelerated by using water, alcohols such as butanol, isopropyl alcohol, ethanol and the like, or phenols or by using, as a catalyst for the reaction, amines such as tributylamine, 1,8-diazabicycloundecene-1 and the like, organic phosphines such as triphenylphosphine, or imidazoles such as 2-phenylimidazole. Preferably, the copolymer [B] should not be miscible with a curable epoxy resin contained in the epoxy resin composition and take a fine island structure in order that the

epoxy resin composition has a high glass transition point, a low coefficient of expansion and a high resistance to cracking. To this end, the solubility parameter of the copolymer is generally from 7.3 to 8.5, preferably from 7.6 to 8.2. For the preparation of the copolymer having such a solubility parameter as defined above, when an equivalent of the amine in the organopolysiloxane is taken as X and the molecular weight of the epoxy resin is taken as Y, the reaction should preferably be conducted within a range $0.7 < X/Y < 7.0$.

When the amount of the copolymers in the epoxy resin composition is less than 1 part by weight per 100 parts by weight of the total of the epoxy resin and the curing agent, the resultant epoxy resin is not satisfactorily improved in the glass transition point and the cracking resistance and may not have a good effect on suppression of an aluminium wiring from movement in case that the composition is used as an encapsulator for a semiconductor device. Over 100 parts by weight, the mechanical strength of the resulting epoxy resin composition tends to lower. Accordingly, the amount is in the range of from 1 to 100 parts by weight, preferably from 2 to 60 parts by weight.

If necessary, the composition of the invention may further comprise various additives which depend on the purpose and the field of application. For instance, release agents such as waxes, fatty acids including stearic acid and metal salts thereof, pigments such as carbon black, dyes, antioxidants, flame retardants, surface treating agents such as $\gamma$-glycidoxypropyltrimethoxysilane, and other additives may be used.

The composition of the invention is obtained by mixing predetermined amounts of the afore-indicated ingredients under agitation, kneading the mixture by means of a kneader, rolls or an extruder preheated to 70 to 95 ° C, cooling and pulverizing the mixture. The order of addition of the respective ingredients is not critical.

The epoxy resin composition of the invention may be suitably used as molding materials and powder coating materials. In addition, the composition is effectively used for sealing or encapsulating semiconductive devices such as IC, LSI, transistors, thyristors, diodes and the like and for the manufacture of printed circuits.

For sealing or encapsulating semiconductive devices, conventionally employed molding techniques such as, for example, transfer molding, injection molding and casting techniques may be used. Preferably, the molding temperature for the epoxy resin composition is in the range of from 150 to 180 ° C and the post curing is effected at a temperature of from 150 to 180 ° C for 2 to 16 hours.

The preparatory examples of the copolymes used in the present invention are shown, in which Preparatory Example 1 is for copolymer [A] , Preparatory Example 2 is for comparison, and Preparatory Example 3 is for copolymer [B] .

Preparatory Example 1

A one liter four neck flask equipped with a reflux condenser, a thermometer, an agitator and a dropping funnel was provided, in which 300 g of an epoxidized phenol novolac resin (epoxy equivalent 195) was charged. Thereafter, while agitating at 110 ° C, a mixture of 32 g of 2-allylphenol and 1 g of tributylamine was dropped in 10 minutes, followed by continuing agitation at a temperature of 110 ° C for further 2 hours. The resulting content was subjected to distillation under reduced pressure to remove unreacted 2-allylphenol and tributylamine therefrom, thereby obtaining an allyl group-containing epoxy resin (allyl equivalent 1490, epoxy equivalent 235).

Subsequently, there were introduced into a four neck flask of the same type as used above 120 g of the allyl group-containing epoxy resin obtained above, 100 g of methylisobutyl ketone, 200 g of toluene, and 0.04 g of a 2-ethylhexanol-modified chloroplatinic acid, followed by azeotropic dehydration for 1 hour. Thereafter, 80 g of organopolysiloxane indicated in Table 1 was dropped at a refluxing temperature in 30 minutes and agitated for reaction at the same temperature for 4 hours. The resulting product was washed with water and the solvent was distilled off under reduced pressure to obtain a reaction product (copolymers I).

Table 1

| | Copolymer I |
|---|---|
| Starting organopoly-siloxane | (note 1) compound (17) |
| Appearance | whitish yellow opaque solid |
| Melt viscosity [Pa·s (cps), 150°C] | 0.890 (890) |
| Loss in weight on heating (%, 150°C, 1 hr) | 0.45 |

(Note 1) Compound (17) :

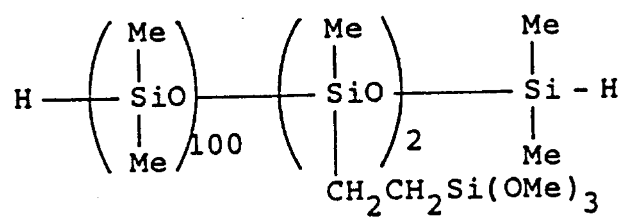

Me : $CH_3$

Preparatory Example 2

The general procedure of Preparatory Example 1 was repeated except that there were used, instead of the allyl group-containing epoxy resin, an allylphenol-containing phenol novolac resin (phenol equivalent 125, allyl equivalent 1100) and organopolysiloxanes indicated in Table 2, thereby obtaining reaction products (copolymers II, III) indicated in Table 2.

Table 2

| | Copolymer II | Copolymer III |
|---|---|---|
| Starting organopoly-siloxane | compound (15) | compound (16) |
| Appearance | brown transparent solid | whitish yellow opaque solid |
| Melt viscosity [Pa·s (cps), 150 °C] | 1.090 (1090) | 1.330 (1330) |
| Loss in weight on heating (%, 150°C, 1 hr) | 0.62 | 0.83 |

Compound (15) :

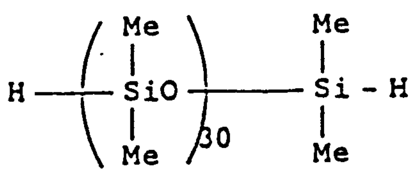

Comound (16) :

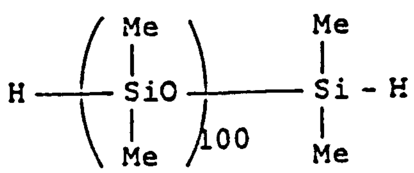

Preparatory Example 3

A one liter four neck flask equipped with a reflux condenser, a thermometer, an agitator and a dropping funnel was provided, in which 150 g of an epoxidized cresol novolac resin (epoxy equivalent 200) having a softening point of 70 °C and 150 g of n-butanol were placed. While agitating at a temperature of 83 °C, 50 g of an amino group-containing organopolysiloxane of the following formula (19) was dropped in 2 hours, followed by agitation at the same temperature for further 6 hours for reaction. Thereafter, the content was subjected to distillation to remove the solvent, thereby obtaining a reaction product (copolymer IV) indicated in Table 3..

Formula (19):

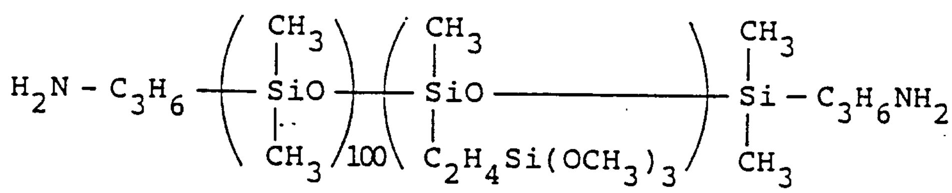

Table 3

| | Copolymer IV |
|---|---|
| Appearance<br>Melt viscosity [Pa• s (cps), 150 °C]<br>Loss in weight on heating (%, 150 °C, 1 hr) | white opaque solid<br>1.930 (1930)<br>0,62 |

The present invention is more particularly described by way of examples and comparative examples but these examples should not be construed as limiting the present invention thereto. In examples and comparative examples, parts are by weight.

Example 1 and Comparative Examples 1 - 3

An epoxidized cresol novolac resin (curable epoxy resin I) having an epoxy equivalent of 200, a phenol novolac resin having a phenol equivalent of 110, the copolymer [A] obtained in Preparatory Example1, triphenylphosphine (TPP), and 1,8-diazabicycloundecene-7 (DBU) were used in amounts indicated in Table 4. There were added to the respective mixtures of 10 parts of a brominated epoxy novolac resin, 260 parts of quartz powder, 1.5 parts of 3-glycidoxypropylmethoxysilane, 1.5 parts of wax E and 1.0 part of carbon black. The resulting compositions were each melted and mixed uniformly by means of two hot rolls to obtain four epoxy resin compositions (Example 1 and Comparative Examples 1 - 3).

These epoxy resin compositions were subjected to the following tests (a) through (e).

(a) Spiral flow value:

A mold as prescribed in the EMMI standards was used and the test was effected under conditions of 175 °C and 6.86 MPa (70 kg/cm$^2$).

(b) Mechanical strength (bending strength and modulus of elasticity in flexure)

According to the method prescribed in JIS K 6911, a bar having a dimension of 10 x 4 x 100 mm, which was molded under conditions of 175 °C and 6.86 MPa (70 kg/cm$^2$) for molding time of 2 minutes and post-cured at 180 °C for 4 hours, was used for the measurement.

(c) Coefficient of expansion and glass transition temperature

A test piece having a size of 4 mm$\phi$ x 15 mm was used and subjected to measuement of the values by heating at a rate of 5 °C per minute by means of a dilatometer.

(d) Cracking resistance

A silicon chip having a dimention of 9.0 x 4.5 x 0.5 mm was adhered to a 14 pin-IC frame (42 alloy), over which an epoxy resin composition was molded under conditions of 180 °C x 2 minutes and post-cured at 180 °C for 4 hours, followed by a repeated heat cycle of -196 °C x 1 minute and 260 °C x 30 seconds. After 50 cycles, the rate of occurrence of the resin crackings was measured (sample number is 50 for each

compositions).

(e) Degree of deformation of an aluminium electrode

An aluminium electrode was vaccum deposited on a silicon chip having a dimension of 3.4 x 10.2 x 0.3 mm to obtain an element for measuring the degree of deformation. This element was bonded on a 14 pin-IC frame (42 alloy) over which an epoxy resin composition was molded under molding conditions of 180 °C x 2 minutes and post-cured at 180 °C for 4 hours, followed by a repeated heat cycle of -196 °C x 1 minute and 260 °C x 30 seconds. After 20 cycles, the degree of deformation of the aluminium electrode was determined (sample number is 3 for each compositions).

The test results are shown in Table 4.

**Table 4**

| | Example 1 | Comparative Example | | |
|---|---|---|---|---|
| | | 1 | 2 | 3 |
| epoxy resin I (parts) | 43 | 56 | 52 | 52 |
| phenolic resin (") | 31 | 34 | 22 | 22 |
| copolymer I (") | 16 | - | - | - |
| copolymer II (") | - | - | 16 | - |
| copolymer III (") | - | - | - | 16 |
| TPP | 1.0 | 1.0 | 1.0 | 1.0 |
| spiral flow (inches) cm | (26) 66.04 | 76,2 (30) | 68.6 (27) | 63.5 (25) |
| bending strength ($kg/cm^2$) $N/cm^2$ | (13.6) 133.3 | 132.3 (13.5) | 123.5 (12.6) | 126.4 (12.9) |
| modulus of elasticity in flexure ($kg/mm^2$) $N/mm^2$ | (1200) 11,760 | 13,720 (1400) | 12,250 (1250) | 12,740 (1300 |
| coefficient of expansion (x $10^{-5}$/ °C) | 1.7 | 1.8 | 1.9 | 1.9 |
| glass transition temperarure (°C) | 170 | 158 | 152 | 155 |
| cracking resistance (%) | 0 | 100 | 46 | 38 |
| degree of deformation of Al electrode (μm) | 0 | 0.4 | 0.8 | 0.6 |

As will be apparent from the results of Table 4, the epoxy resin composition comprising copolymer [A] obtained by the reaction between epoxy resins and the specific type of organopolysiloxanes has not only a

coefficient of expansion equal to or less than the copolymer [A]-free epoxy resin composition without impeding mechanical strengths such as the bending strength and the modulus of elasticity in flexure, but also a higher glass transition temperature better cracking resistance and smaller degree of deformation of the aluminium electrode. Thus the epoxy resin composition of the invention will be found to be suitable as a molding material, a powder coating material and a sealant for semiconductors.

Example 2 and Comparative Examples 4, 5

An epoxidized cresol novolac resin (curable epoxy resin II) having an epoxy equivalent of 200, a phenol novolac resin having a phenol equivalent of 110, copolymer [B] prepared in Preparatory Example 3, triphenyl phosphine (TPP) and 1,8-diazabicycloundecene-7 (DBU) were formulated as shown in Table 5, to which 10 parts of a brominated epoxy novolac resin, 10 parts by antimony trioxide, 1.5 parts of 3-glycidoxypropyltrimethoxysilane, 1.5 parts of wax E and 1.0 part of carbon black were added. The mixtures were uniformly melted and mixed by means of two hot rolls to obtain 3 epoxy resin compositions(Example 2 and Comparative Examples 4, 5).

The epoxy resin compositions were subjected to tests (a) through (e). The results are shown in Table 5 below.

As will be apparent from the results of Table 5, the epoxy resin composition formulated with copolymer [B] obtained by the reaction between epoxy resins and amino group-containing organopolysiloxanes having a specific degree of polymerization (N = 20 - 400) has, without reduction of mechanical strengths such as the bending strength and the modulus of elasticity in flexure, a coefficient of expansion equal to or less than the coplymer [B]-free epoxy resin compositions, and also has a higher glass transition temperature, a better cracking resistance and a smaller degree of deformation of the aluminium electrode. Thus, the epoxy resin compositions of the invention are suitable for use as molding materials, powder coating materials and sealants for semiconductors.

Examles 3 and 4

The general procedure of Example 2 was repeated except that there was used instead of epoxy resin II a novolac resin of epoxidized disphenol A (epoxy resin III) having an epoxy equivalent of 220 or a tris (4-glycidoxyphenyl)methane dimer (epoxy resin IV) having an epoxy equivalent of 195 and that the amounts of phenolic resin and copolymers were as indicated in Table 6, thereby obtaining epoxy resin compositions. These compositions were subjucted to tests (a) through (e).

Table 5

| | Example | Comparative Example | |
|---|---|---|---|
| | 2 | 4 | 5 |
| epoxy resin II (parts) | 42 | 56 | 53 |
| phenolic resin (") | 32 | 34 | 31 |
| copolymer IV (") | 16 | - | - |
| TPP (") | 1.0 | 1.0 | 1.0 |
| spiral flow (inches) cm | 71.12 (28) | 76.2 (30) | 60.96 (24) |
| bending strength (kg/mm$^2$) N/mm$^2$ | 140.1 (14.3) | 132.3 (13.5) | 96.0 (9.8) |
| modulus of elasticity in flexure (kg/mm$^2$)N/mm$^2$ | 12,348 (1260) | 13,720 (1400) | 10,290 (1050) |
| coefficient of expansion (x $10^{-5}$/°C) | 1.7 | 1.8 | 1.9 |
| glass transition temperature (°C) | 172 | 158 | 165 |
| cracking resitance (%) | 0 | 100 | 46 |
| degree of deformation of Al electrode (µm) | 0 | 0.4 | 0.6 |
| mold releasability | 0 | 0 | x |

The test results are also shown in Table 6.

Table 6

| | Example | |
|---|---|---|
| | 3 | 4 |
| epoxy resin III (parts) | 44 | - |
| epoxy resin IV (parts) | - | 41 |
| phenolic resin (parts) | 30 | 33 |
| copolymer IV (parts) | 16 | 16 |
| | - | - |
| spiral flow (inches) cm | 71,12 (28) | 76.2 (30) |
| bending strength $(kg/mm^2) N/mm^2$ | 143.1 (14.6) | 138.2 (14.1) |
| modulus of elasticity in flexure $(kg/mm^2)$ $N/mm^2$ | 12,152 (1240) | 11,760 (1200) |
| coefficient of expansion (x $10^{-5}/°C$) | 1.7 | 1.7 |
| glass transition temperature (°C) | 179 | 187 |
| cracking resistance (%) | 0 | 0 |
| degree of deformation of Al electrode (μm) | 0 | 0 |
| mold releasability | o | o |

The results of Table 6 reveal that the epoxy resin compositions formulated with the copolymers [B] according to the invention do not lower in fluidity and mechanical strength and have a low coefficient of expansion, a high glass transition point, a good cracking resistance and a small degree of deformation of the aluminium wiring.

## Claims

**1.** An epoxy resin composition which comprises

(I) a curable epoxy resin having at least two epoxy groups and which is not modified with silicones,

(II) a curing agent selected from the group consisting of diaminodiphenylmethane, diaminodiphenylsulfone, metaphenylenediamine, acid anhydride curing agents and phenol novolac curing agents having two or more hydroxyl groups in the molecule,

(III) an inorganic filler in an amount of 100 to 1000 parts by weight per 100 parts by weight of the total of the epoxy resin and the curing agent,

(IV) at least one copolymer selected from the following copolymers [A] and [B] in an amount of 1 to 100 parts by weight per 100 parts by weight of the total of the epoxy resin and the curing agent,

[A] copolymers obtained by addition reaction between alkenyl group-containig epoxy resins and hydrogen-terminated (2-trimethoxysilylethyl)-polysiloxanes of the following formula (1)

$$H_aR_bSiO_{\frac{4-(a+b)}{2}} \qquad (1)$$

in which each R represents a substituted or unsubstituted monovalent hydrocarbon group, "a" is a value of from 0.01 to 0.1, "b" is a value of 1.8 to 2.2 and $1.81 < a + b < 2.3$, and the number of silicon atoms in a molecule is an integer of from 20 to 400 and the number of hydrogen atoms directly connected to silicon atom is an integer of from 1 to 5;

[B] a copolymer obtained by an addition reaction between novolak epoxy resins and amino group-containing organopolysiloxanes of the following formula (2)

$$(H_2N\text{-}R^1)_aR^2_bSiO_{\frac{4-(a+b)}{2}} \qquad (2)$$

in which $R^1$ represents a divalent organic group, $R^2$ is independently selected from methyl group,

phenyl group,
$-CH_2CH_2Si(OCH_3)_3$ and

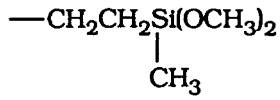

wherein part of said $R^2$'s is
$-CH_2CH_2Si(OCH_3)_3$ or

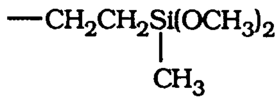

"a" is a value of from 0.01 to 0.1, "b" is a value of from 1.8 to 2.2 and $1.81 < a + b < 2.3$, and the number of silicon atoms in one molecule is an integer of from 20 to 400.

2. A composition according to Claim 1, wherein said curable epoxy resin is at least one resin selected from the group consisting of substituted or unsubstituted novolak-type epoxy resins and bisphenol A-type epoxy resins.

**Patentansprüche**

1. Epoxyharzzusammensetzung, umfassend
   (I) ein härtbares Epoxyharz mit mindestens zwei Epoxygruppen, welches nicht mit Silikonen modifiziert ist,
   (II) ein Härtungsmittel, welches aus der aus Diaminodiphenylmethan, Diaminodiphenylsulfon, Metaphenylendiamin, Säureanhydrid-Härtungsmitteln und Phenol-Novolak-Härtungsmitteln mit zwei oder mehreren Hydroxylgruppen im Molekül bestehenden Gruppe gewählt ist,
   (III) einen anorganischen Füllstoff in einer Menge von 100 bis 1000 Gew.-Teilen pro 100 Gew.-Teilen der Gesamtmenge aus dem Epoxyharz und dem Härtungsmittel,
   (IV) mindestens ein Copolymer, welches aus den folgenden Copolymeren [A] und [B] gewählt ist, in einer Menge von 1 bis 100 Gew.-Teilen pro 100 Gew. -Teile der Gesamtmenge aus dem Epoxyharz und dem Härtungsmittel
   [A] Copolymere, welche erhalten werden durch Additionsreaktion zwischen Alkenylgruppen enthaltenden Epoxyharzen und (2-Trimethoxysilylethyl)-polysiloxanen mit endständigem Wasserstoff der folgenden Formel (1):

$$H_aR_bSiO_{\frac{4-(a+b)}{2}} \qquad (1)$$

   worin jedes Reine substituierte oder unsubstituierte, einwertige Kohlenwasserstoffgruppe, "a" einen Wert von 0.01 bis 0,1, "b" einen Wert von 1,8 bis 2,2 und $1,81 < a+b < 2,3$ bedeuten, wobei die Anzahl von Siliziumatomen in einem Molekül eine ganze Zahl von 20 bis 400 ist und die Anzahl von Wasserstoffatomen, welche direkt mit einem Siliziumatom verbunden sind, eine ganze Zahl von 1 bis 5 ist:
   [B] ein Copolymer, welches erhalten wird durch eine Additionsreaktion zwischen Novolak-Epoxy-Harzen und Aminogruppen enthaltenden Organopolysiloxanen der folgenden Formel (2):

$$(H_2N\text{-}R^1)_aR^2_bSiO_{\frac{4-(a+b)}{2}} \qquad (2)$$

worin $R^1$ eine zweiwertige organische Gruppe ist, $R^2$ unabhängig aus einer Methylgruppe, Phenylgruppe,
$-CH_2CH_2Si(OCH_3)_3$ und

$$-CH_2CH_2\underset{\displaystyle CH_3}{\underset{|}{Si}}(OCH_3)_2$$

worin ein Teil der $R^2$'s
$-CH_2CH_2Si(OCH_3)_3$ oder

$$-CH_2CH_2\underset{\displaystyle CH_3}{\underset{|}{Si}}(OCH_3)_2$$

ist,
gewählt ist, "a" ein Wert von 0,01 bis 0,1 ist, "b" ein Wert von 1,8 bis 2,2 ist, wobei $1,81 < a+b < 2,3$, und wobei die Anzahl der Siliziumatome in einem Molekül eine ganze Zahl von 20 bis 400 ist.

**2.** Zusammensetzung nach Anspruch 1, wobei das härtbare Epoxyharz mindestens ein Harz ist, welches aus der aus substituierten oder unsubstituierten Epoxyharzen vom Novolak-Typ und Epoxyharzen vom Bisphenol A-Typ bestehenden Gruppe gewählt ist.

**Revendications**

**1.** Composition de résine époxy qui comprend
(I) une résine époxy durcissable ayant au moins deux groupes époxy et qui n'est pas modifiée par des silicones,
(II) un agent durcisseur choisi dans le groupe formé par le diaminodiphénylméthane, la diaminodiphénylsulfone, la métaphénylènediamine, des agents durcisseurs du type anhydride d'acide et des agents durcisseurs du type novolaque phénolique dont la molécule contient deux ou plusieurs groupes hydroxyle,
(III) une charge minérale en une quantité de 100 à 1000 parties en poids pour 100 parties en poids du total de la résine époxy et de l'agent durcisseur,
(IV) au moins un copolymère choisi parmi les copolymères [A] et [B] suivants en une quantité de 1 à 100 parties en poids pour 100 parties en poids du total de la résine époxy et de l'agent durcisseur,
[A] les copolymères obtenus par réaction d'addition entre des résines époxy contenant des groupes alcényle et des (2-triméthoxysilyléthyl)polysiloxanes terminés par de l'hydrogène répondant à la formule (1) suivante

$$H_aR_bSiO_{\frac{4-(a+b)}{2}} \quad (1)$$

dans laquelle chaque R représente un groupe hydrocarboné monovalent substitué ou non substitué, "a" est une valeur de 0,01 à 0,1, "b" est une valeur de 1,8 à 2,2 et $1,81 < a + b < 2,3$, et le nombre d'atomes de silicium dans une molécule est un nombre entier de 20 à 400 et le nombre d'atomes d'hydrogène directement liés à des atomes de silicium est un nombre entier de 1 à 5 ;
[B] les copolymères obtenus par réaction d'addition entre des résines novolaques époxy et des organopolysiloxanes contenant des groupes amino répondant à formule (2) suivante

$$(H_2N\text{-}R^1)_a R^2_b SiO_{\frac{4-(a+b)}{2}} \qquad (2)$$

dans laquelle $R^1$ représente un groupe organique divalent, $R^2$ est choisi indépendamment parmi un groupe méthyle, un groupe phényle,

$-CH_2CH_2Si(OCH_3)_3$ et

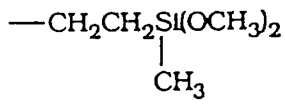

une partie desdits $R^2$ étant

$-CH_2CH_2Si(OCH_3)_3$ ou

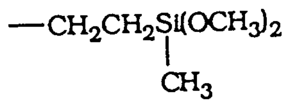

"a" est une valeur de 0,01 à 0,1, "b" est une valeur de 1,8 à 2,2 et $1,81 < a + b < 2,3$, et le nombre d'atomes de silicium dans une molécule est un nombre entier de 20 à 400.

**2.** Composition selon la revendication 1, dans laquelle ladite résine époxy durcissable est au moins une résine choisie dans le groupe formé par les résines époxy du type novolaque substituées ou non substituées et les résines époxy du type bisphénol A.